# EUROPÄISCHE PATENTSCHRIFT

(11) **EP 3 738 410 B1**
(45) Veröffentlichungstag und Bekanntmachung des Hinweises auf die Patenterteilung: **20.08.2025**
(21) Anmeldenummer: 18826800.7
(22) Anmeldetag: 27.11.2018
(51) Int. Cl.: H05B 6/12

(54) **KOCHFELDBAUSATZ ZU EINER HERSTELLUNG VON KOCHFELDERN**
COOKING HOB KIT FOR MANUFACTURING COOKING HOBS
KIT DE PLAQUE DU CUISSON POUR LA FABRICATION DES PLAQUES DE CUISSON

(30) Priorität: 08.01.2018 ES 201830013
(43) Veröffentlichungstag der Anmeldung: 18.11.2020
(73) Patentinhaber: BSH Hausgeräte GmbH, 81739 München (DE)
(72) Erfinder: BLASCO RUEDA, Nicolas, 50007 Zaragoza (ES); LAFUENTE URETA, Julio, 50018 Zaragoza (ES); MOYA NOGUES, Jesus Manuel, 50008 Zaragoza (ES); ORTIZ SAINZ, David, 50298 Pinseque (Zaragoza) (ES); PALACIOS TOMAS, Daniel, 50008 Zaragoza (ES); PUYAL PUENTE, Diego, 50014 Zaragoza (ES); VALEAU MARTIN, David, 50010 Zaragoza (ES)
(86) Internationale Anmeldenummer: PCT/IB2018/059323
(87) Internationale Veröffentlichungsnummer: WO 2019/135119

(56) Entgegenhaltungen:
- EP-A1- 2 127 477
- EP-A1- 2 451 245
- EP-A2- 2 506 675
- WO-A1-2008/061908
- DE-U1- 202008 016 268

## Beschreibung

Die Erfindung betrifft einen Bausatz zu einer Herstellung von Kochfeldern nach Anspruch 1, ein mit Hilfe des Bausatzes hergestelltes Kochfeld nach Anspruch 13 und ein Verfahren zu einer Herstellung eines Kochfelds mittels eines Bausatzes nach dem Anspruch 14. Aus dem Stand der Technik sind Kochfelder mit unterschiedlichen Anzahlen an Heizeinheiten bekannt. Jedes der Kochfelder weist einen Satz an Baueinheiten auf, welche speziell für das entsprechende Kochfeld vorgesehen sind. Der Satz von Baueinheiten umfasst eine Hauptenergieversorgungsplatine und eine Filtereinheit. Jedes der Kochfelder wird demnach individuell hergestellt und jedes der Kochfelder weist eigene, ausschließlich für dieses Kochfeld vorgesehene Baueinheiten auf.

EP 2 451 245 A1 (PANASONIC CORP [JP]) 9. Mai 2012 (2012-05-09) beschreibt eine Induktionskochfeldvorrichtung mit einer ersten Wechselrichterplatine 8a, welche eine erste Energieversorgungsplatine 21a aufweist und einer von der ersten Wechselrichterplatine 8a getrennten zweiten Wechselrichterplatine 8b, welche eine zweite Energieversorgungsplatine 21b aufweist.

Die Aufgabe der Erfindung besteht insbesondere darin, eine hohe Flexibilität bei der Herstellung von Kochfeldern vorteilhaft zu ermöglichen. Die Aufgabe wird erfindungsgemäß durch die Merkmale der Ansprüche 1, 13 und 14 gelöst, während vorteilhafte Ausgestaltungen und Weiterbildungen der Erfindung den Unteransprüchen entnommen werden können.

Es wird ein Bausatz, insbesondere ein Kochfeldbausatz und vorteilhaft ein Induktionskochfeldbausatz, vorgeschlagen zu einer Herstellung von Kochfeldern, insbesondere von Induktionskochfeldern, mit unterschiedlicher Anzahl an Heizeinheiten, mit einem Satz von identischen Hauptenergieversorgungsplatinen und mit einem Satz von Nebenenergieversorgungsplatinen, welche zu einer Herstellung von Kochfeldern mit unterschiedlicher Anzahl an Heizeinheiten wahlweise mit einer der Hauptenergieversorgungsplatinen, insbesondere mittelbar oder unmittelbar, verbindbar sind.

Durch eine derartige erfindungsgemäße Ausgestaltung kann vorteilhaft eine hohe Flexibilität, insbesondere bei der Herstellung von Kochfeldern, erreicht werden. Aufgrund des Satzes von identischen Hauptenergieversorgungsplatinen kann insbesondere eine geringe Lagerhaltung und/oder eine schnelle Herstellung von Kochfeldern mit unterschiedlicher Anzahl an Heizeinheiten ermöglicht werden. Insbesondere kann eine geringe Anzahl an elektrischen und/oder elektronischen Baueinheiten ermöglicht werden, wodurch geringe Kosten erzielt und/oder eine technisch unkomplizierte und/oder wenig fehleranfällige Ausgestaltung erreicht werden kann. Es kann bei einer Herstellung von Kochfeldern mit unterschiedlicher Anzahl an Heizeinheiten insbesondere auf eine langwierige Suche nach einer für das herzustellende Kochfeld passenden Hauptenergieversorgungsplatine verzichtet werden, wodurch insbesondere eine einfache und/oder schnelle und/oder unkomplizierte Herstellung erzielt und/oder geringe Kosten erreicht werden können. Insbesondere kann eine einfache Ausgestaltung eines mittels des Bausatzes hergestellten Kochfelds ermöglicht werden, da insbesondere lediglich eine einzige Steuereinheit, welche insbesondere Teil der Hauptenergieversorgungsplatine ist, vorgesehen werden kann, wodurch insbesondere auf weitere Steuereinheiten und/oder auf eine Kommunikation zwischen verschiedenen Steuereinheiten verzichtet werden kann. Aufgrund des Satzes von identischen Hauptenergieversorgungsplatinen kann insbesondere eine kompakte und/oder platzsparende Ausgestaltung erzielt werden, wodurch ein hierdurch frei werdender Platz vorteilhaft für Nebenenergieversorgungsplatinen und/oder für eine Erhöhung einer Anzahl an Heizeinheiten, insbesondere einer Anzahl an Anschlussmöglichkeiten für Heizeinheiten, genutzt werden kann.

Unter einem "Bausatz", insbesondere unter einem "Kochfeldbausatz" soll insbesondere eine Ansammlung an Objekten verstanden werden, welche zu einer Herstellung von unterschiedlichen Geräten, insbesondere zu einer Herstellung von unterschiedlichen Kochfeldern, wahlweise miteinander kombinierbar sind. Unter einer "Heizeinheit" soll in diesem Zusammenhang insbesondere eine Einheit verstanden werden, welche dazu vorgesehen ist, in wenigstens einem Betriebszustand zumindest einem Gargeschirr Energie zum Zweck einer Beheizung des Gargeschirrs zuzuführen. Beispielsweise könnte die Heizeinheit als Widerstandsheizeinheit ausgebildet sein und insbesondere dazu vorgesehen sein, Energie in Wärme umzuwandeln und diese dem Gargeschirr zum Zweck einer Beheizung des Gargeschirrs zuzuführen. Alternativ oder zusätzlich könnte die Heizeinheit als Induktionsheizeinheit ausgebildet sein und insbesondere dazu vorgesehen sein, Energie in Form eines elektromagnetischen Wechselfelds dem Gargeschirr zuzuführen, wobei die dem Gargeschirr zugeführte Energie insbesondere in dem Gargeschirr in Wärme umgewandelt werden könnte.

Unter einem "Satz" von Objekten soll insbesondere eine Anzahl von mindestens zwei und vorteilhaft von mindestens drei Objekten verstanden werden, wobei insbesondere auch eine Anzahl von mindestens vier, vorteilhaft von mindestens fünf, besonders vorteilhaft von mindestens acht, vorzugsweise von mindestens zehn und besonders bevorzugt von einer Vielzahl an Objekten denkbar ist.

Unter einer "Hauptenergieversorgungsplatine" soll insbesondere eine Einheit verstanden werden, welche in wenigstens einem Betriebszustand insbesondere Energie zu einer Versorgung zumindest eines Objekts bereitstellt und/oder welche insbesondere zumindest eine Hauptsteuereinheit aufweist, die in wenigstens einem Betriebszustand insbesondere zumindest eine Hauptfunktion zumindest einer Energieversorgungsvorrichtung steuert und/oder regelt.

Insbesondere weist ein mit dem Bausatz hergestelltes Kochfeld die Energieversorgungsvorrichtung auf. In wenigstens einem Betriebszustand sind zumindest eine der Hauptenergieversorgungsplatinen und zumindest eine der Nebenenergieversorgungsplatinen wenigstens teilweise Teil der Energieversorgungsvorrichtung und bilden insbesondere die Energieversorgungsvorrichtung wenigstens teilweise aus. Insbesondere weisen zumindest eine der Hauptenergieversorgungsplatinen und zumindest eine der Nebenenergieversorgungsplatinen in wenigstens einem Betriebszustand insbesondere zumindest eine Energieversorgungseinheit und/oder zumindest eine Schaltmatrix, wie beispielweise zumindest eine Konfigurationseinheit und/oder zumindest eine Aktivierungseinheit, und/oder zumindest eine kapazitive Einheit auf.

Jede Hauptenergieversorgungsplatine könnte in wenigstens einem Betriebszustand beispielsweise eigenständig und/oder von sich aus und/oder direkt Energie, insbesondere in Form von elektrischem Strom, bereitstellen. Beispielsweise könnte jede Hauptenergieversorgungsplatine zumindest eine Energieversorgungseinheit aufweisen, mittels welcher die Hauptenergieversorgungsplatine in wenigstens einem Betriebszustand insbesondere Energie bereitstellen könnte. Alternativ oder zusätzlich könnte jede Hauptenergieversorgungsplatine in wenigstens einem Betriebszustand insbesondere indirekt Energie, insbesondere in Form von elektrischem Strom, bereitstellen. Beispielsweise könnte jede Hauptenergieversorgungsplatine zumindest eine Hauptsteuereinheit aufweisen, welche insbesondere zu einer Ansteuerung zumindest einer Energieversorgungseinheit vorgesehen sein könnte, die in Abhängigkeit von einer Ansteuerung durch die Hauptsteuereinheit in wenigstens einem Betriebszustand insbesondere Energie bereitstellen könnte.

Unter einer "Hauptsteuereinheit" soll insbesondere eine Steuereinheit zumindest einer Hauptenergieversorgungsplatine verstanden werden, welche in wenigstens einem Betriebszustand insbesondere zumindest eine Hauptfunktion zumindest einer Energieversorgungsvorrichtung ausführt. Unter einer "Steuereinheit" soll insbesondere eine elektronische Einheit verstanden werden, welche in wenigstens einem Betriebszustand insbesondere zu einer Verarbeitung zumindest eines elektronischen Signals vorgesehen ist. Beispielsweise könnte die Steuereinheit in einer Steuer- und/oder Regeleinheit eines Kochfelds zumindest teilweise integriert sein und vorzugsweise dazu vorgesehen sein, zumindest die Heizeinheiten zu steuern und/oder zu regeln. Vorzugsweise umfasst die Steuereinheit eine Recheneinheit und insbesondere zusätzlich zur Recheneinheit eine Speichereinheit mit einem darin gespeicherten Steuer- und/oder Regelprogramm, das dazu vorgesehen ist, von der Recheneinheit ausgeführt zu werden.

Unter einer "Energieversorgungseinheit" soll insbesondere eine Einheit verstanden werden, welche in wenigstens einem Betriebszustand Energie, insbesondere in Form von elektrischem Strom, bereitstellt und welche insbesondere an eine Netzspannung angeschlossen ist. Insbesondere ist die Energieversorgungseinheit als eine Stromversorgungseinheit ausgebildet.

Beispielsweise könnte die Energieversorgungseinheit in wenigstens einem Betriebszustand insbesondere direkt an die insbesondere als Wechselspannung ausgebildete Netzspannung angeschlossen sein. Die Netzspannung könnte beispielsweise von einem elektrischen Netzwerk eines Kochfelds bereitgestellt werden. Alternativ oder zusätzlich könnte die Energieversorgungseinheit insbesondere in wenigstens einem Betriebszustand indirekt, beispielsweise über zumindest eine Gleichrichtereinheit, an die insbesondere eine als Wechselspannung ausgebildete Netzspannung angeschlossen sein. Die Gleichrichtereinheit könnte beispielsweise Teil des, insbesondere mittels des Bausatzes hergestellten, Kochfelds sein und insbesondere zumindest einen Gleichrichter aufweisen.

Unter einer "Nebenenergieversorgungsplatine" soll insbesondere eine Einheit verstanden werden, welche zu einer Verbindung mit der Hauptenergieversorgungsplatine und/oder zu einer Ansteuerung durch die Hauptenergieversorgungsplatine vorgesehen ist und welche insbesondere in wenigstens einem Betriebszustand insbesondere ausschließlich gemeinsam mit der Hauptenergieversorgungsplatine Energie bereitstellt. Beispielsweise könnte die Nebenenergieversorgungsplatine zumindest eine Energieversorgungseinheit aufweisen und insbesondere in Abhängigkeit von einer Ansteuerung durch die Hauptenergieversorgungsplatine Energie bereitstellen. Alternativ oder zusätzlich könnte die Nebenenergieversorgungsplatine insbesondere in wenigstens einem Betriebszustand Energie von der Hauptenergieversorgungsplatine empfangen. Insbesondere könnte die Nebenenergieversorgungsplatine die empfangene Energie in wenigstens einem Betriebszustand, insbesondere an zumindest ein weiteres Objekt, insbesondere an zumindest eine Heizeinheit, weiterleiten. Alternativ oder zusätzlich könnte die Nebenenergieversorgungsplatine die empfangene Energie in wenigstens einem Betriebszustand insbesondere verteilen und/oder zuordnen, und zwar insbesondere an an der Nebenenergieversorgungsplatine angeschlossene Heizeinheiten.

Insbesondere könnten die Nebenenergieversorgungsplatinen analog zueinander aufgebaut und/oder ausgebildet sein. Beispielsweise könnten zumindest zwei der und vorteilhaft jede der Nebenenergieversorgungsplatinen zumindest einen Grundaufbau aufweisen. Der Grundaufbau könnte beispielsweise eine Anzahl an Objekten und/oder eine Position an Objekten sein, welche insbesondere den Nebenenergieversorgungsplatinen gemeinsam sein könnte. In Abhängigkeit einer Eigenschaft und/oder Charakteristik zumindest einer der Nebenenergieversorgungsplatinen könnte die Nebenenergieversorgungsplatine insbesondere zusätzlich zu dem Grundaufbau zumindest ein weiteres Objekt aufweisen. Das Objekt könnte beispielsweise ein Heizeinheitenausgang und/oder ein Zuordnungsschaltelement und/oder zumindest ein Aktivierungsschaltelement und/oder zumindest eine kapazitive Baueinheit sein.

Unter der Wendung, dass ein Objekt und ein weiteres Objekt "verbindbar" sind, soll insbesondere verstanden werden, dass das Objekt und das weitere Objekt zu einer Herstellung einer insbesondere elektrischen Verbindung zwischen dem Objekt und dem weiteren Objekt vorgesehen sind. Insbesondere sind das Objekt und das weitere Objekt in wenigstens einem Betriebszustand elektrisch miteinander verbunden.

Beispielsweise könnte eine Hauptenergieversorgungsplatine mit zumindest zwei identischen Nebenenergieversorgungsplatinen verbindbar sein. Die identischen Nebenenergieversorgungsplatinen könnten insbesondere auf verschiedenen Seiten der Hauptenergieversorgungsplatine angeordnet und auf der entsprechenden Seite mit der Hauptenergieversorgungsplatine verbindbar sein. Hierdurch kann insbesondere eine optimale und/oder hohe Konfigurierbarkeit erreicht werden.

Zumindest zwei der Nebenenergieversorgungsplatinen könnten beispielsweise unterschiedlich sein und sich in zumindest einer Eigenschaft voneinander unterscheiden. Insbesondere könnte für die Herstellung eines bestimmten Kochfelds aus den zumindest zwei unterschiedlichen Nebenenergieversorgungsplatinen zumindest eine für das bestimmte Kochfeld passende Nebenenergieversorgungsplatine ausgesucht und/oder herausgegriffen und insbesondere mit der Hauptenergieversorgungsplatine verbunden werden. Alternativ oder zusätzlich könnten zumindest zwei der Nebenenergieversorgungsplatinen beispielsweise identisch ausgebildet und insbesondere mit zumindest einer insbesondere gemeinsamen Hauptenergieversorgungsplatine verbindbar sein. Die zumindest zwei identischen Nebenversorgungsplatinen könnten beispielsweise jeweils direkt mit der Hauptenergieversorgungsplatine verbindbar sein, beispielsweise auf zwei verschiedenen Seiten der Hauptenergieversorgungsplatine. Alternativ oder zusätzlich könnte zumindest eine der zumindest zwei identischen Nebenversorgungsplatinen beispielsweise indirekt, und zwar insbesondere über zumindest eine weitere der identischen Nebenenergieversorgungsplatinen, insbesondere modulartig, mit der Hauptenergieversorgungsplatine verbindbar sein. Beispielsweise könnte jede der zumindest zwei identischen Nebenenergieversorgungsplatinen eine identische und insbesondere vordefinierte Anzahl an Heizeinheitenausgängen aufweisen. Insbesondere könnte durch modulartige Kombination von Nebenversorgungsplatinen der zumindest zwei identischen Nebenenergieversorgungsplatinen eine gewünschte Anzahl an Heizeinheitenausgängen realisiert und/oder eingestellt werden.

Unter "vorgesehen" soll insbesondere speziell programmiert, ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt.

Ferner wird vorgeschlagen, dass jede der Hauptenergieversorgungsplatinen zumindest eine Hauptsteuereinheit aufweist, welche zu einer Steuerung der Heizeinheiten vorgesehen ist. In wenigstens einem Betriebszustand steuert und/oder regelt die Hauptsteuereinheit insbesondere die Heizeinheiten. Beispielsweise steuert und/oder regelt die Hauptsteuereinheit in wenigstens einem Betriebszustand insbesondere eine Energiezufuhr zu den Heizeinheiten und/oder einen Aktivitätsgrad der Heizeinheiten. Dadurch kann insbesondere auf weitere Steuereinheiten und/oder auf eine Kommunikation zwischen verschiedenen Steuereinheiten verzichtet werden, wodurch insbesondere eine einfache und/oder unkomplizierte und/oder funktionstüchtige Ausgestaltung erzielt werden kann.

Zudem wird vorgeschlagen, dass jede der Hauptenergieversorgungsplatinen zumindest eine Energieversorgungseinheit aufweist, welche zu einer Versorgung der Heizeinheiten mit elektrischer Energie, insbesondere in Form von elektrischem Strom, vorgesehen ist. In wenigstens einem Betriebszustand stellt jede der Hauptenergieversorgungsplatinen insbesondere elektrische Energie insbesondere direkt bereit. Dadurch kann insbesondere eine kompakte Ausgestaltung erzielt werden.

Beispielsweise könnte jede Hauptenergieversorgungsplatine zumindest eine Kühlungseinheit aufweisen, welche insbesondere benachbart zu der Energieversorgungseinheit angeordnet und zu einer Kühlung der Energieversorgungseinheit vorgesehen sein könnte. Insbesondere könnte jede Hauptenergieversorgungsplatine zumindest eine Leiterplatte aufweisen, auf welcher insbesondere die Energieversorgungseinheit angeordnet sein könnte. Die Kühlungseinheit könnte beispielsweise benachbart zu der Leiterplatte angeordnet sein. Vorzugsweise weist jede der Hauptenergieversorgungsplatinen zumindest eine Leiterplatte und zumindest eine Kühlungseinheit auf, welche auf der Leiterplatte angeordnet und zu einer Kühlung der Energieversorgungseinheit vorgesehen ist. Unter einer "Leiterplatte" soll insbesondere eine Einheit verstanden werden, welche in wenigstens einem Betriebszustand zumindest eine elektrische und/oder elektronische Baueinheit trägt und welche insbesondere zu einer mechanischen Befestigung und/oder zu einer elektrischen Kontaktierung zumindest einer elektrischen und/oder elektronischen Baueinheit vorgesehen ist. Insbesondere besteht die Leiterplatte wenigstens zu einem Großteil aus elektrisch isolierendem Material. Die Leiterplatte weist insbesondere zumindest eine Leiterbahn und zumindest einen Grundkörper auf, auf welchem die Leiterbahn wenigstens zu einem Großteil angeordnet ist. Unter "wenigstens zu einem Großteil" soll insbesondere zu einem Anteil, insbesondere einem Massenanteil und/oder Volumenanteil, von mindestens 70 %, insbesondere von mindestens 80 %, vorteilhaft von mindestens 90 % und vorzugsweise von mindestens 95 % verstanden werden. Unter einer "Kühlungseinheit" soll insbesondere eine Einheit verstanden werden, welche in wenigstens einem Betriebszustand insbesondere zu einer Kühlung der Energieversorgungseinheit vorgesehen ist und welche in wenigstens einem Betriebszustand insbesondere Wärme absorbiert und/oder aufnimmt und/oder abführt. In wenigstens einem Betriebszustand ist die Energieversorgungseinheit insbesondere in einem Nahbereich der Kühlungseinheit und vorteilhaft in insbesondere mechanischem Kontakt mit der Kühlungseinheit angeordnet. Jede Hauptenergieversorgungsplatine weist insbesondere zumindest eine Isolationseinheit auf, welche in wenigstens einem Betriebszustand insbesondere zwischen der Leiterplatte und der Kühlungseinheit angeordnet ist und welche insbesondere die Leiterplatte und die Kühlungseinheit gegeneinander isoliert. Dadurch kann insbesondere eine Überhitzung der Energieversorgungseinheit vermieden und/oder eine langlebige Ausgestaltung erzielt werden.

Beispielsweise könnte die Energieversorgungseinheit insbesondere insgesamt eine Anzahl von mindestens fünfzehn, insbesondere von mindestens siebzehn, vorteilhaft von mindestens zwanzig und vorzugsweise von mindestens fünfundzwanzig Energieversorgungsausgängen aufweisen. Vorzugsweise weist die Energieversorgungseinheit insbesondere insgesamt eine Anzahl von maximal zwölf, insbesondere von maximal zehn, vorteilhaft von maximal acht und vorzugsweise von maximal sechs Energieversorgungsausgängen auf, welche insbesondere als Stromversorgungsausgänge ausgebildet sind. Insbesondere weist die Energieversorgungseinheit insbesondere pro Phase eine Anzahl von maximal sechs, insbesondere von maximal fünf, vorteilhaft von maximal vier und vorzugsweise von maximal drei Energieversorgungsausgängen auf, welche insbesondere als Stromversorgungsausgänge ausgebildet sind. Die Energieversorgungseinheit weist pro Energieversorgungsausgang insbesondere zumindest eine Heizfrequenzeinheit auf. Insbesondere könnten zumindest zwei der Heizfrequenzeinheiten an unterschiedliche Netzstromspannungsphasen angeschlossen sein. Beispielsweise könnte ein Anteil von wenigstens im Wesentlichen 50 % der Heizfrequenzeinheiten an zumindest eine erste Netzstromspannungsphase und ein Anteil von wenigstens im Wesentlichen 50 % der Heizfrequenzeinheiten an zumindest eine zweite Netzstromspannungsphase angeschlossen sein, welche sich insbesondere von der ersten Netzstromspannungsphase unterscheidet. Unter einer "Heizfrequenzeinheit" soll insbesondere eine elektrische Einheit verstanden werden, die ein oszillierendes elektrisches Signal, vorzugsweise mit einer Frequenz von zumindest 1 kHz, insbesondere von wenigstens 10 kHz vorteilhaft von mindestens 20 kHz, und insbesondere von maximal 100 kHz für eine Induktionsheizeinheit erzeugt. Insbesondere ist die Heizfrequenzeinheit dazu vorgesehen, eine, von der Induktionsheizeinheit geforderte, maximale elektrische Leistung von zumindest 1000 W, insbesondere zumindest 2000 W, vorteilhaft zumindest 3000 W und vorzugsweise zumindest 3500 W bereitzustellen. Die Heizfrequenzeinheit umfasst insbesondere zumindest einem Wechselrichter, der vorzugsweise zumindest zwei, vorzugsweise in Reihe geschaltete, bidirektionale unipolare Schalter, die insbesondere von einem Transistor und einer parallel geschalteten Diode gebildet sind, und besonders vorteilhaft zumindest jeweils einen parallel zu den bidirektionalen unipolaren Schaltern geschaltete Dämpfungskapazität, die insbesondere von zumindest einem Kondensator gebildet ist, aufweist. Hierdurch kann eine hochfrequente Energieversorgung der Induktionsheizeinheit bereitgestellt werden. Ein Spannungsabgriff der Heizfrequenzeinheit ist insbesondere an einer gemeinsamen Kontaktstelle zweier bidirektionaler unipolarer Schalter angeordnet. Dadurch können insbesondere geringe Kosten erzielt werden.

Zudem wird vorgeschlagen, dass sich zumindest zwei und insbesondere zumindest drei der Nebenenergieversorgungsplatinen hinsichtlich einer Anzahl an Heizeinheitenausgängen unterscheiden. Unter einem "Heizeinheitenausgang" soll insbesondere eine Anschlussstelle verstanden werden, welche zu einem Anschluss einer Heizeinheit insbesondere zum Zweck einer Energieversorgung der Heizeinheit vorgesehen ist. In wenigstens einem Betriebszustand ist insbesondere zumindest eine der Heizeinheiten an zumindest einem der Heizeinheitenausgänge elektrisch leitend angeschlossen. Insbesondere weist eine erste Nebenenergieversorgungsplatine der Nebenenergieversorgungsplatinen eine Anzahl an Heizeinheitenanschlüssen auf, welche größer ist als eine Anzahl an Heizeinheitenanschlüssen einer zweiten Nebenenergieversorgungsplatine der Nebenenergieversorgungsplatinen. Dadurch können insbesondere in einfacher Weise Kochfelder mit unterschiedlichen Anzahlen an Heizeinheiten hergestellt werden.

Weiterhin wird vorgeschlagen, dass sich zumindest zwei der Nebenenergieversorgungsplatinen hinsichtlich einer Anzahl an Zuordnungsschaltelementen unterscheiden, welche zu einer Zuordnung der Heizeinheitenausgänge zu der Energieversorgungseinheit vorgesehen sind. Insbesondere sind die Zuordnungsschaltelemente Teil einer Zuordnungsschalteinheit. Unter einer "Zuordnungsschalteinheit" soll insbesondere eine Einheit verstanden werden, welche in wenigstens einem Betriebszustand insbesondere zumindest einen der Heizeinheitenausgänge zu der Energieversorgungseinheit zuordnet und diesen zumindest einen Heizeinheitenausgang insbesondere elektrisch leitend mit der Energieversorgungseinheit verbindet. Unter einem "Zuordnungsschaltelement" soll insbesondere ein Schaltelement der Zuordnungsschalteinheit verstanden werden, mittels welchem insbesondere eine elektrisch leitende Verbindung zwischen zumindest einem der Heizeinheitenausgänge und der Energieversorgungseinheit herstellbar ist. Insbesondere weist die Zuordnungsschalteinheit zumindest zwei, insbesondere zumindest vier, vorteilhaft zumindest sechs, besonders vorteilhaft zumindest acht, vorzugsweise zumindest zehn und besonders bevorzugt eine Vielzahl an Zuordnungsschaltelementen auf. Zumindest ein Teil der Zuordnungsschaltelemente könnte beispielsweise nebeneinander und/oder gleichwertig relativ zueinander geschaltet sein. Alternativ oder zusätzlich könnte zumindest ein Teil der Zuordnungsschaltelemente beispielsweise hintereinander geschaltet sein. Insbesondere weist eine erste Nebenenergieversorgungsplatine der Nebenenergieversorgungsplatinen eine Anzahl an Zuordnungsschaltelementen auf, welche größer ist als eine Anzahl an Zuordnungsschaltelementen einer zweiten Nebenenergieversorgungsplatine der Nebenenergieversorgungsplatinen. Dadurch können insbesondere für Kochfelder mit unterschiedlichen Anzahlen an Heizeinheiten die jeweiligen Heizeinheiten der Energieversorgungseinheit zugeordnet werden, und zwar insbesondere unter Vermeidung einer zu hohen Anzahl an Zuordnungsschaltelemente und damit insbesondere unter Vermeidung unnötiger Kosten.

Ferner wird vorgeschlagen, dass sich zumindest zwei der Nebenenergieversorgungsplatinen hinsichtlich einer Anzahl an Aktivierungsschaltelementen unterscheiden, welche jeweils einem der Heizeinheitenausgänge zugeordnet und zu einer Aktivierung und/oder Deaktivierung des jeweiligen Heizeinheitenausgangs vorgesehen sind. Unter einem "Aktivierungsschaltelement" soll insbesondere ein Schaltelement verstanden werden, mittels welchem in wenigstens einem Betriebszustand insbesondere zumindest ein Heizeinheitenausgang der Heizeinheitenausgänge aktivierbar und/oder deaktivierbar ist. Beispielsweise könnte eine Anzahl an Heizeinheitenausgängen größer sein als eine Anzahl an Aktivierungsschaltelementen. Insbesondere könnte zumindest ein Aktivierungsschaltelement zu einer Aktivierung und/oder Deaktivierung von zumindest zwei Heizeinheitenausgängen vorgesehen sein. Vorteilhaft ist eine Anzahl an Heizeinheitenausgängen und eine Anzahl an Aktivierungsschaltelementen identisch. Insbesondere ist jeweils ein Aktivierungsschaltelement der Aktivierungsschaltelemente einem, insbesondere genau einem Heizeinheitenausgang der Heizeinheitenausgänge zugeordnet. Mittels des dem Heizeinheitenausgang der Heizeinheitenausgänge zugeordneten Aktivierungsschaltelements ist in wenigstens einem Betriebszustand insbesondere eine elektrisch leitende Verbindung zwischen dem Heizeinheitenausgang und der Energieversorgungseinheit und/oder der Zuordnungsschalteinheit herstellbar und/oder trennbar. Dadurch kann insbesondere jeder der Heizeinheitenausgänge gezielt und/oder unabhängig von weiteren Heizeinheitenausgängen aktiviert und/oder deaktiviert werden, wodurch insbesondere eine hohe Flexibilität ermöglicht werden kann.

Zudem wird vorgeschlagen, dass sich zumindest zwei der Nebenenergieversorgungsplatinen hinsichtlich einer Anzahl an kapazitiven Baueinheiten, insbesondere an Resonanzkapazitäten, unterscheiden. Unter einer "kapazitiven Baueinheit" soll insbesondere eine Einheit verstanden werden, welche zumindest einen Kondensator aufweist. Beispielsweise könnte die kapazitive Baueinheit eine insbesondere beliebige Reihenschaltung und/oder Parallelschaltung an Kondensatoren aufweisen. Alternativ könnte die kapazitive Baueinheit insbesondere genau einen Kondensator aufweisen. Insbesondere weist eine erste Nebenenergieversorgungsplatine der Nebenenergieversorgungsplatinen eine Anzahl an kapazitiven Baueinheiten auf, welche größer ist als eine Anzahl an kapazitiven Baueinheiten einer zweiten Nebenenergieversorgungsplatine der Nebenenergieversorgungsplatinen. Dadurch kann insbesondere eine optimierte Ausgestaltung erzielt werden, da insbesondere eine Anzahl an kapazitiven Baueinheiten und eine Anzahl an Heizeinheitenausgängen aufeinander abgestimmt werden kann.

Beispielsweise könnten zumindest zwei der und insbesondere alle Nebenenergieversorgungsplatinen bei einer Betrachtung in einer Draufsicht auf eine Haupterstreckungsebene der jeweiligen Nebenenergieversorgungsplatine eine wenigstens im Wesentlichen und insbesondere vollständig identische Flächenerstreckung aufweisen. Vorzugsweise unterscheiden sich zumindest zwei der Nebenenergieversorgungsplatinen bei einer Betrachtung in einer Draufsicht auf eine Haupterstreckungsebene der jeweiligen Nebenenergieversorgungsplatine hinsichtlich einer Flächenerstreckung. Unter einer "Haupterstreckungsebene" eines Objekts soll insbesondere eine Ebene verstanden werden, welche parallel zu einer größten Seitenfläche eines kleinsten gedachten geometrischen Quaders ist, welcher das Objekt gerade noch vollständig umschließt, und insbesondere durch den Mittelpunkt des Quaders verläuft. Insbesondere weist eine erste Nebenenergieversorgungsplatine der Nebenenergieversorgungsplatinen bei einer Betrachtung in einer Draufsicht auf eine Haupterstreckungsebene der ersten Nebenenergieversorgungsplatine eine Flächenerstreckung auf, welche größer ist als eine Flächenerstreckung einer zweiten Nebenenergieversorgungsplatine der Nebenenergieversorgungsplatinen bei einer Betrachtung in einer Draufsicht auf eine Haupterstreckungsebene der zweiten Nebenenergieversorgungsplatine. Dadurch kann insbesondere eine einfache Unterscheidbarkeit zwischen verschiedenen Nebenenergieversorgungsplatinen erreicht werden, wodurch insbesondere eine schnelle und/oder unkomplizierte und/oder kostengünstige Herstellung von Kochfeldern mit unterschiedlichen Anzahlen an Heizeinheiten ermöglicht werden kann.

Insbesondere wird vorgeschlagen, dass die Nebenenergieversorgungsplatinen in ähnlicher Weise aufgebaut sind und sich insbesondere lediglich hinsichtlich einer Anzahl an Objekten, insbesondere an Heizeinheitenausgängen und/oder an Zuordnungsschaltelementen und/oder an Aktivierungsschaltelementen und/oder an kapazitiven Baueinheiten, und/oder hinsichtlich einer Flächenerstreckung unterscheiden. Dadurch können die unterschiedlichen Nebenenergieversorgungsplatinen insbesondere in einfacher und/oder kostengünstiger Weise hergestellt und/oder entwickelt werden. Insbesondere kann eine einfache Instandhaltung und/oder Wartung der unterschiedlichen Nebenenergieversorgungsplatinen ermöglicht werden.

Ferner wird vorgeschlagen, dass der Bausatz einen Satz von identischen Gebläseeinheiten aufweist, welche zu einer Herstellung von Kochfeldern mit unterschiedlicher Anzahl an Heizeinheiten wahlweise mit einer der Hauptenergieversorgungsplatinen, insbesondere mittelbar oder unmittelbar, verbindbar sind. Unter einer "Gebläseeinheit" soll insbesondere eine Einheit verstanden werden, welche insbesondere zumindest ein Lüfterrad aufweist und welche, insbesondere mittels des Lüfterrads, in wenigstens einem Betriebszustand insbesondere zumindest einen Luftstrom bereitstellt, und zwar insbesondere zu einer Kühlung zumindest eines weiteren Objekts, wie insbesondere der Kühlungseinheit. Insbesondere sind in wenigstens einem Betriebszustand die Gebläseeinheit und die Kühlungseinheit strömungstechnisch miteinander verbunden. Die Gebläseeinheit könnte beispielsweise einteilig ausgebildet sein und, insbesondere ausschließlich, das Lüfterrad aufweisen. Alternativ könnte die Gebläseeinheit insbesondere mehrteilig ausgebildet sein und insbesondere zusätzlich zu dem Lüfterrad zumindest eine Kanaleinheit aufweisen, welche in wenigstens einem Betriebszustand insbesondere das Lüfterrad und die Kühlungseinheit strömungstechnisch miteinander verbinden könnte. Insbesondere könnte die Gebläseeinheit zumindest ein Gebläsegehäuse aufweisen, in welchem das Lüfterrad insbesondere angeordnet sein könnte. Dadurch kann insbesondere eine geringe Lagerhaltung und/oder eine geringe Bauteilevielfalt ermöglicht und/oder auf unterschiedliche Gebläseeinheiten verzichtet werden, wodurch insbesondere eine schnelle und/oder unkomplizierte und/oder kostengünstige Herstellung von Kochfeldern mit unterschiedlichen Anzahlen an Heizeinheiten ermöglicht werden kann.

Zudem wird vorgeschlagen, dass der Bausatz einen Satz von identischen Filtereinheiten aufweist, welche zu einer Herstellung von Kochfeldern mit unterschiedlicher Anzahl an Heizeinheiten wahlweise mit einer der Hauptenergieversorgungsplatinen, insbesondere mittelbar oder unmittelbar, verbindbar sind. Unter einer "Filtereinheit" soll insbesondere eine Einheit verstanden werden, welche insbesondere zumindest eine Filterteileinheit aufweist und welche insbesondere in wenigstens einem Betriebszustand, insbesondere mittels der Filterteileinheit, zumindest ein insbesondere elektrisches Signal in Abhängigkeit von zumindest einer Frequenz in zumindest einer Signaleigenschaft, wie beispielsweise zumindest einer Signalamplitude und/oder zumindest einer Signalphasenlage, verändert, um insbesondere unerwünschte Signalanteile abzuschwächen und/oder zu unterdrücken. Unter einer "Filtereinheit" soll insbesondere eine Einheit verstanden werden, welche insbesondere zumindest einen insbesondere elektrischen Filter aufweist. Die Filtereinheit könnte beispielsweise einteilig ausgebildet sein und, insbesondere ausschließlich, die Filterteileinheit aufweisen. Alternativ könnte die Filtereinheit insbesondere mehrteilig ausgebildet sein und insbesondere zumindest zwei Filterteileinheiten aufweisen. Zumindest zwei der Filterteileinheiten könnten beispielsweise identisch sein. Alternativ oder zusätzlich könnten sich zumindest zwei der Filterteileinheiten in wenigstens einem Merkmal voneinander unterscheiden. Beispielsweise könnte zumindest eine erste Filterteileinheit, insbesondere ausschließlich, den Filter und zumindest eine zweite Filterteileinheit zusätzlich zu dem Filter zumindest eine Steuereinheit aufweisen. Dadurch kann insbesondere eine geringe Fehlerquote und/oder eine geringe Defektquote von mittels des Bausatzes hergestellten Kochfeldern ermöglicht werden, da insbesondere unerwünschte Signalanteile abgeschwächt und/oder unterdrückt werden können.

Insbesondere könnte der Bausatz einen Satz von Kochfeldaußengehäuseeinheiten aufweisen. Insbesondere könnte zumindest eine der Hauptenergieversorgungsplatinen und/oder zumindest eine der Nebenenergieversorgungsplatinen und/oder zumindest eine der Filtereinheiten und/oder zumindest eine der Gebläseeinheiten zu einer Anordnung innerhalb zumindest einer der Kochfeldaußengehäuseeinheiten vorgesehen sein. Die Kochfeldaußengehäuseeinheiten könnten sich insbesondere bei einer Betrachtung in einer Draufsicht auf eine Haupterstreckungsebene zumindest eines Gehäusebodens der jeweiligen Kochfeldaußengehäuseeinheit hinsichtlich einer Flächenerstreckung unterscheiden. Zumindest eine der Kochfeldaußengehäuseeinheiten könnte beispielsweise mehrteilig ausgebildet sein und insbesondere zumindest eine Außengehäuseeinheit und zumindest eine Innengehäuseeinheit aufweisen. Die Innengehäuseeinheit könnte insbesondere zu einer Anordnung innerhalb der Außengehäuseeinheit und insbesondere zusätzlich zu einer Isolation zwischen zumindest einem Objekt, insbesondere zwischen der Hauptenergieversorgungsplatine und/oder der Filtereinheit, und der Außengehäuseeinheit vorgesehen sein. Dadurch kann insbesondere eine kompakte Ausgestaltung erzielt werden, da insbesondere eine Kochfeldgehäuseeinheit mit einer entsprechenden Flächenerstreckung gewählt werden kann.

Eine kostengünstige Ausgestaltung und/oder ein einfach zu wartendes Kochfeld kann insbesondere erreicht werden durch ein Kochfeld, insbesondere durch ein Induktionskochfeld, welches mittels des erfindungsgemäßen Bausatzes hergestellt ist.

Eine Flexibilität kann insbesondere weiter gesteigert werden durch ein Verfahren zu einer Herstellung eines Kochfelds mittels des erfindungsgemäßen Bausatzes zu einer Herstellung von Kochfeldern mit unterschiedlicher Anzahl an Heizeinheiten, wobei der Bausatz einen Satz von identischen Hauptenergieversorgungsplatinen und einen Satz von Nebenenergieversorgungsplatinen aufweist, welche zu einer Herstellung von Kochfeldern mit unterschiedlicher Anzahl an Heizeinheiten wahlweise mit einer der Hauptenergieversorgungsplatinen, insbesondere mittelbar oder unmittelbar, verbunden werden.

Der Bausatz soll hierbei nicht auf die oben beschriebene Anwendung und Ausführungsform beschränkt sein. Insbesondere kann der Bausatz zu einer Erfüllung einer hierin beschriebenen Funktionsweise eine von einer hierin genannten Anzahl an einzelnen Elementen, Bauteilen und Einheiten abweichende Anzahl aufweisen.

Es zeigen:
- Fig. 1: ein Kochfeld, welches mittels eines Bausatzes hergestellt ist, in einer schematischen Darstellung,
- Fig. 2: ein Satz von Aufstellplatten des Bausatzes in einer schematischen Darstellung,
- Fig. 3: ein Satz von Kochfeldaußengehäuseeinheiten des Bausatzes in einer schematischen Darstellung,
- Fig. 4: ein Satz von Hauptenergieversorgungsplatinen des Bausatzes in einer schematischen Darstellung,
- Fig. 5: ein Satz von Nebenenergieversorgungsplatinen des Bausatzes in einer schematischen Darstellung,
- Fig. 6: ein Satz von Gebläseeinheiten des Bausatzes in einer schematischen Darstellung,
- Fig. 7: ein Satz von Filtereinheiten des Bausatzes in einer schematischen Darstellung,
- Fig. 8: ein Verfahren zu einer Herstellung eines Kochfelds mittels des Bausatzes in einem Verfahrensschritt in einer schematischen Draufsicht,
- Fig. 9: das Verfahren in einem weiteren Verfahrensschritt in einer schematischen Draufsicht,
- Fig. 10: das Verfahren in einem weiteren Verfahrensschritt in einer schematischen Draufsicht,
- Fig. 11: das Verfahren in einem weiteren Verfahrensschritt in einer schematischen Draufsicht und
- Fig. 12: einen Ausschnitt eines Schaltbilds eines mittels des Bausatzes hergestellten Kochfelds in einer schematischen Darstellung.

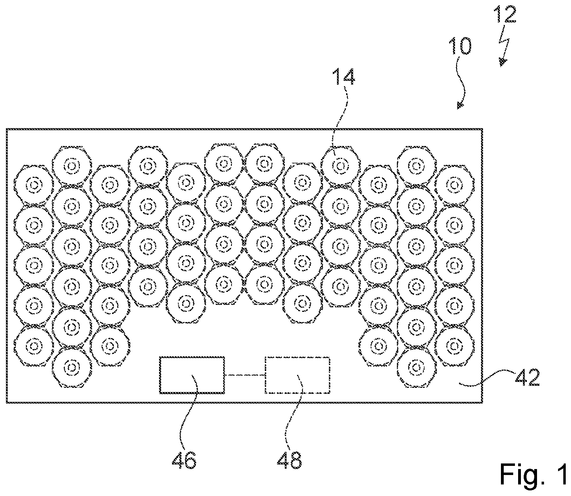

Fig. 1 zeigt ein Kochfeld 12, welches als ein Induktionskochfeld ausgebildet ist. Das Kochfeld 12 ist mittels eines Bausatzes 10 hergestellt. Der Bausatz 10 ist als ein Kochfeldbausatz ausgebildet. Der Bausatz 10 ist zu einer Herstellung von Kochfeldern 12 mit unterschiedlicher Anzahl an Heizeinheiten 14 vorgesehen. Im vorliegenden Ausführungsbeispiel wurde mittels des Bausatzes 10 ein Kochfeld 12 mit insgesamt sechsundfünfzig Heizeinheiten 14 hergestellt. Alternativ sind mittels des Bausatzes 10 Kochfelder 12 mit unterschiedlicher Anzahl an Heizeinheiten14 herstellbar.

Im Folgenden wird die Herstellung der Kochfelder 12 mittels des Bausatzes 10 anhand des Kochfelds 12 mit den insgesamt sechsundfünfzig Heizeinheiten 14 beschrieben. Der im Folgenden beschriebene Bausatz 10 ist zu einer Herstellung von drei unterschiedlichen Kochfeldern 12 vorgesehen. Dies ist lediglich beispielhaft. Der Bausatz 10 könnte insbesondere zu einer Herstellung einer größeren oder kleineren Anzahl an unterschiedlichen Kochfeldern 12 vorgesehen sein.

Das mittels des Bausatzes 10 hergestellte Kochfeld 12 weist eine Aufstellplatte 42 auf. Im vorliegenden Ausführungsbeispiel ist die Aufstellplatte 42 als eine Kochfeldplatte ausgebildet. In einem montierten Zustand bildet die Aufstellplatte 42 einen Teil eines Kochfeldaußengehäuses aus, und zwar insbesondere eines Kochfeldaußengehäuses insbesondere des Kochfelds 12. Die Aufstellplatte 42 ist zu einem Aufstellen von Gargeschirr vorgesehen (nicht dargestellt).

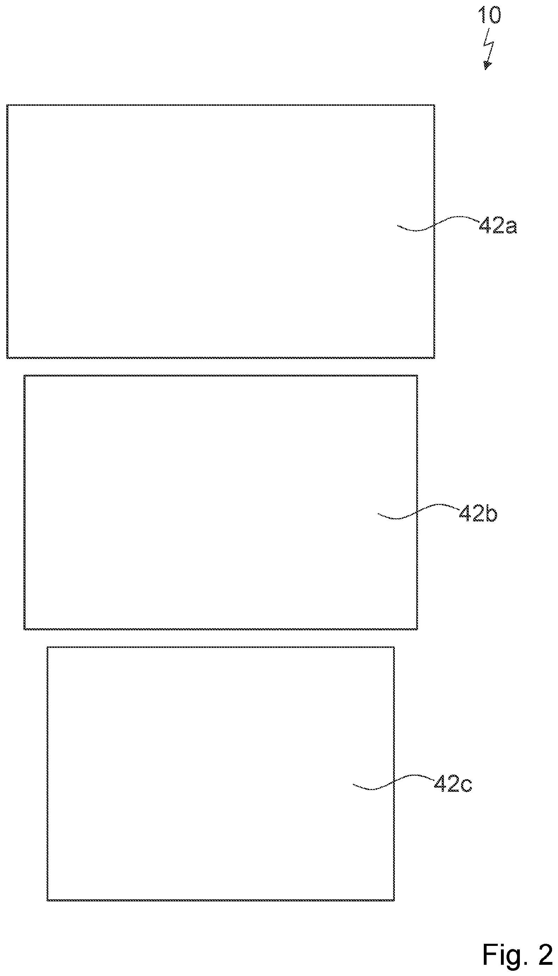

Der Bausatz 10 weist einen Satz von Aufstellplatten 42 auf (vgl. Fig. 2). Die Aufstellplatten 42 unterscheiden sich bei einer Betrachtung in einer Draufsicht auf eine Haupterstreckungsebene der jeweiligen Aufstellplatte 42 hinsichtlich einer Flächenerstreckung. Im vorliegenden Ausführungsbeispiel weist der Satz von Aufstellplatten 42 auf drei unterschiedlichen Aufstellplatten 42a, 42b, 42c auf.

Das mittels des Bausatzes 10 hergestellte Kochfeld 12 weist eine Bedienerschnittstelle 46 zu einer Eingabe und/oder Auswahl von Betriebsparametern auf, beispielsweise einer Heizleistung und/oder einer Heizleistungsdichte und/oder einer Heizzone. Die Bedienerschnittstelle 46 ist zu einer Ausgabe eines Werts eines Betriebsparameters an einen Bediener vorgesehen.

Der Bausatz 10 weist einen Satz von Bedienerschnittstellen 46 auf (nicht dargestellt). Die Bedienerschnittstellen 46 sind im vorliegenden Ausführungsbeispiel identisch. Alternativ könnten sich die Bedienerschnittstellen 46 des Bausatzes 10 in zumindest einem Merkmal unterscheiden.

Das mittels des Bausatzes 10 hergestellte Kochfeld 12 weist eine Kochfeldsteuereinheit 48 auf. Die Kochfeldsteuereinheit 48 ist dazu vorgesehen, in Abhängigkeit von mittels der Bedienerschnittstelle 46 eingegebenen Betriebsparametern Aktionen auszuführen und/oder Einstellungen zu verändern. Die Kochfeldsteuereinheit 48 regelt in einem Heizbetriebszustand eine Energiezufuhr zu den Heizeinheiten 14.

Der Bausatz 10 weist einen Satz von Kochfeldsteuereinheiten 48 auf (nicht dargestellt). Die Kochfeldsteuereinheiten 48 sind im vorliegenden Ausführungsbeispiel unterschiedlich, und zwar insbesondere bezüglich zumindest eines Merkmals. Die Kochfeldsteuereinheiten 48 unterscheiden sich hinsichtlich einer programmierten Software, welche insbesondere zu einer Ansteuerung der Heizeinheiten 14 vorgesehen ist. Im vorliegenden Ausführungsbeispiel weist der Satz von Kochfeldsteuereinheiten 48 drei unterschiedliche Kochfeldsteuereinheiten 48a, 48b, 48c auf. Alternativ könnten die Kochfeldsteuereinheiten 48 des Bausatzes 10 identisch sein.

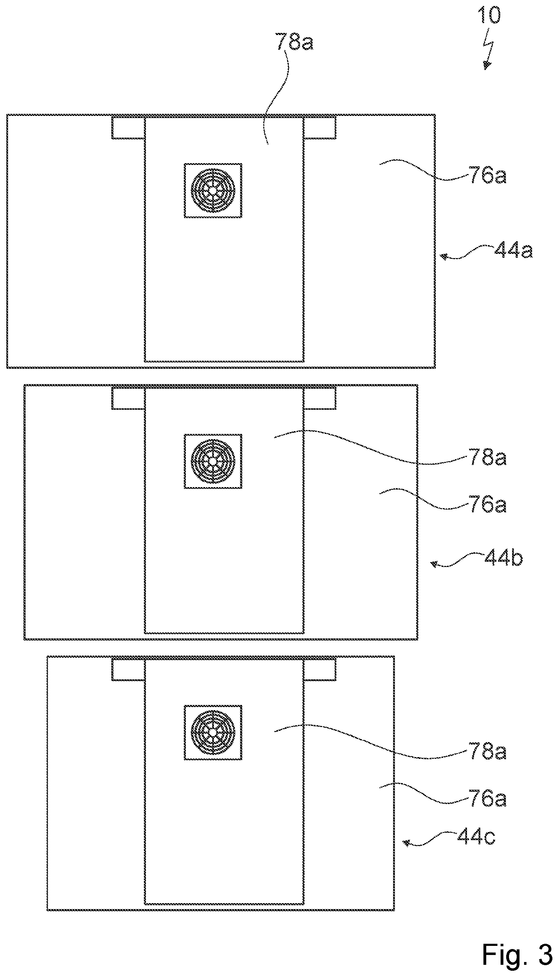

Das mittels des Bausatzes 10 hergestellte Kochfeld 12 weist eine Kochfeldaußengehäuseeinheit 44 auf (vgl. unter anderem Fig. 3). In einem Betriebszustand bildet die Kochfeldaußengehäuseeinheit 44 einen Teil des Kochfeldaußengehäuses aus. Die Kochfeldaußengehäuseeinheit 44 bildet in einem Betriebszustand gemeinsam mit der Aufstellplatte 42 das Kochfeldaußengehäuse aus. Die Kochfeldaußengehäuseeinheit 44 definiert teilweise einen Lagerraum. In einem Betriebszustand definiert die Kochfeldaußengehäuseeinheit 44 gemeinsam mit der Aufstellplatte 42 den Lagerraum.

Der Bausatz 10 weist einen Satz von Kochfeldaußengehäuseeinheiten 44 auf (vgl. Fig. 3). Die Kochfeldaußengehäuseeinheiten 44 unterscheiden sich bei einer Betrachtung in einer Draufsicht auf eine Haupterstreckungsebene eines Gehäusebodens der jeweiligen Kochfeldaußengehäuseeinheit 44 hinsichtlich einer Flächenerstreckung. Im vorliegenden Ausführungsbeispiel weist der Satz von Kochfeldaußengehäuseeinheiten 44 drei unterschiedliche Kochfeldaußengehäuseeinheiten 44a, 44b, 44c auf.

Jede der Kochfeldaußengehäuseeinheiten 44 weist eine Außengehäuseeinheit 76 auf. Jede der Kochfeldaußengehäuseeinheiten 44 weist eine Innengehäuseeinheit 78 auf. Die Innengehäuseeinheit 78 ist zu einer Anordnung innerhalb der Außengehäuseeinheit 76 vorgesehen. In einem Betriebszustand eines mittels des Bausatzes 10 hergestellten Kochfelds 12 ist die Innengehäuseeinheit 78 innerhalb der Außengehäuseeinheit 76 angeordnet.

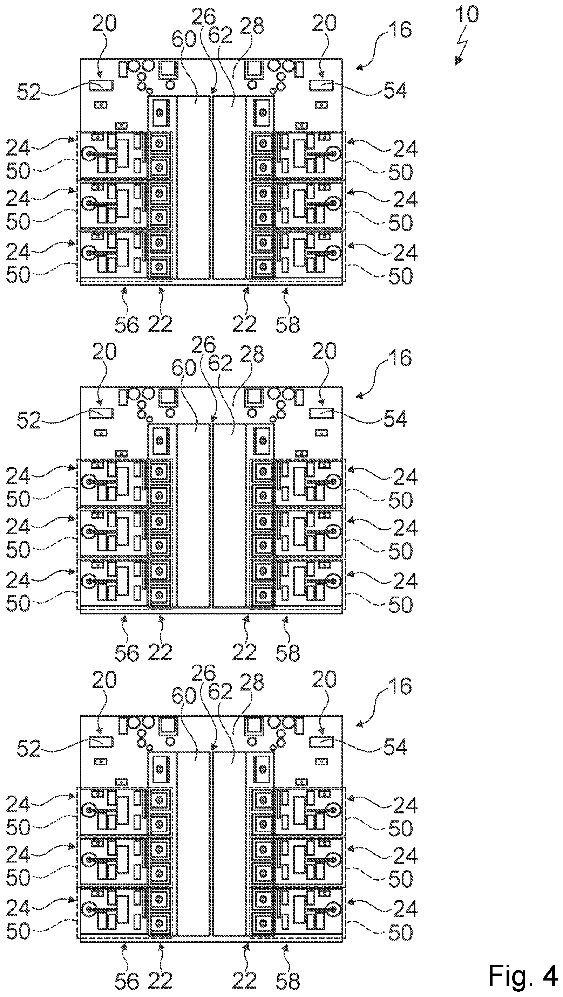

Der Bausatz 10 weist einen Satz von identischen Hauptenergieversorgungsplatinen 16 auf (vgl. Fig. 4). Alle Hauptenergieversorgungsplatinen 16 des Satzes von identischen Hauptenergieversorgungsplatinen 16 sind identisch ausgebildet. Im vorliegenden Ausführungsbeispiel weist der Satz von identischen Hauptenergieversorgungsplatinen 16 drei identische Hauptenergieversorgungsplatinen 16 auf.

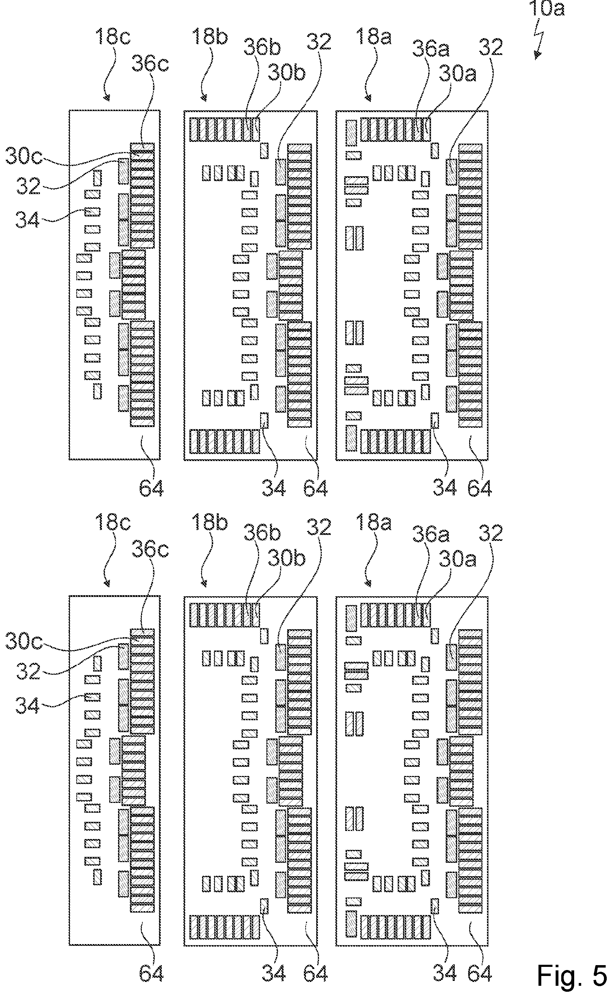

Der Bausatz 10 weist einen Satz von Nebenenergieversorgungsplatinen 18 auf (vgl. Fig. 5). Der Satz von Nebenenergieversorgungsplatinen 18 weist im vorliegenden Ausführungsbeispiel insgesamt sechs Nebenenergieversorgungsplatinen 18 auf. Jeweils zwei der Nebenenergieversorgungsplatinen 18 sind identisch ausgebildet. Der Satz von Nebenenergieversorgungsplatinen 18 weist drei verschiedene Arten und/oder Typen an Nebenenergieversorgungsplatinen 18a, 18b, 18c auf. Im Folgenden wird lediglich eine der Nebenenergieversorgungsplatinen 18a, 18b, 18c beschrieben.

Die Nebenenergieversorgungsplatinen 18 sind zu einer Herstellung von Kochfeldern 12 mit unterschiedlicher Anzahl an Heizeinheiten 14 wahlweise mit einer der Hauptenergieversorgungsplatinen 16 verbindbar. Im vorliegenden Ausführungsbeispiel sind jeweils zwei insbesondere gleichartige Nebenenergieversorgungsplatinen 18 zu einer Herstellung von Kochfeldern 12 mit unterschiedlicher Anzahl an Heizeinheiten 14 wahlweise mit einer der Hauptenergieversorgungsplatinen 16 verbindbar.

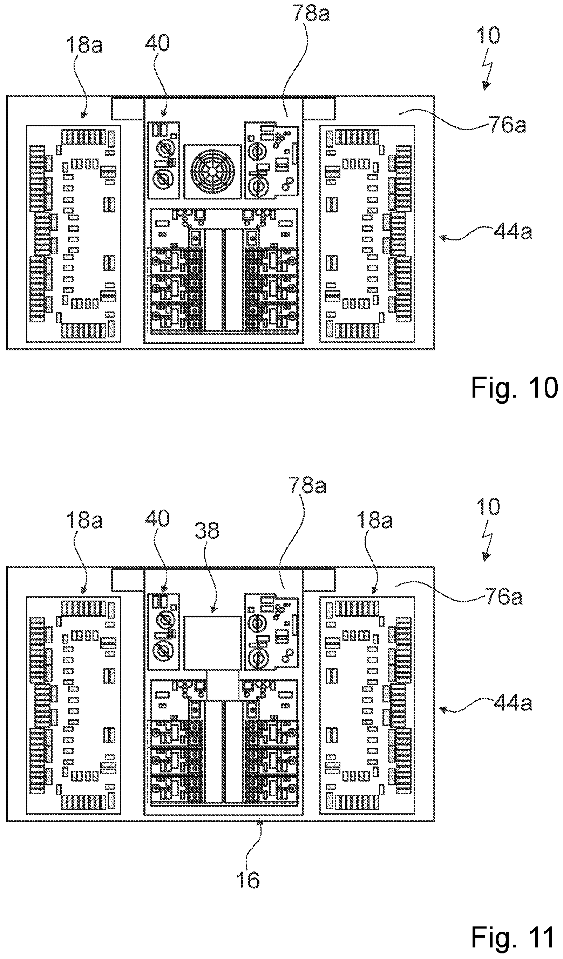

Die zwei Nebenenergieversorgungsplatinen 18, welche mit einer insbesondere gemeinsamen der Hauptenergieversorgungseinheiten 16 verbindbar sind, sind bezüglich eines Mittelpunkts und/oder Schwerpunkts der Hauptenergieversorgungspletine 16 auf einander gegenüberliegenden Seiten der Hauptenergieversorgungspletine16 mit der entsprechenden Hauptenergieversorgungsplatine 16 verbindbar (vgl. Fig. 10 und 11).

Jede der Hauptenergieversorgungsplatinen 16 weist eine Hauptsteuereinheit 20 auf. Die Hauptsteuereinheit 20 ist zu einer Steuerung der Heizeinheiten 14 vorgesehen. Die Hauptsteuereinheit 20 weist im vorliegenden Ausführungsbeispiel zwei Steuerteileinheiten 52, 54 auf. Jeweils eine der Steuerteileinheiten 52, 54 ist einem Teil der Heizeinheiten 14 zugeordnet. Jeweils eine der Steuerteileinheiten 52, 54 ist einer der Nebenenergieversorgungsplatinen 18 zugeordnet.

Die Hauptsteuereinheit 20 ist zu einer Kommunikation mit den Nebenenergieversorgungsplatinen 18 vorgesehen. Jede der Steuerteileinheiten 52, 54 ist zu einer Kommunikation mit einer der Nebenenergieversorgungsplatinen 18 vorgesehen.

Jede der Hauptenergieversorgungsplatinen 16 weist eine Energieversorgungseinheit 22 auf. Die Energieversorgungseinheit 22 jeder der Hauptenergieversorgungsplatinen 16 ist zu einer Versorgung der Heizeinheiten 14 mit elektrischer Energie vorgesehen. Die Energieversorgungseinheit 22 weist im vorliegenden Ausführungsbeispiel zwei Energieversorgungsteileinheiten 56, 58 auf. Jeweils eine der Energieversorgungsteileinheiten 56, 58 ist einem Teil der Heizeinheiten 14 zugeordnet. Jeweils eine der Energieversorgungsteileinheiten 56, 58 ist einer der Nebenenergieversorgungsplatinen 18 zugeordnet.

Die Energieversorgungseinheit 22 weist im vorliegenden Ausführungsbeispiel insgesamt sechs Heizfrequenzeinheiten 50 auf. Von mehrfach vorhandenen Objekten ist in den Figuren jeweils lediglich eines mit einem Bezugszeichen versehen. Pro Energieversorgungsteileinheit 56, 58 weist die Energieversorgungseinheit 22 drei Heizfrequenzeinheiten 50 auf.

Jede der Energieversorgungsteileinheiten 56, 58 ist an eine eigene Netzstromspannungsphase angeschlossen. Eine erste der Energieversorgungsteileinheiten 56, 58 und insbesondere die Heizfrequenzeinheiten 50 der ersten der Energieversorgungsteileinheiten 56, 58 ist an eine erste Netzstromspannungsphase angeschlossen. Eine zweite der Energieversorgungsteileinheiten 56, 58 und insbesondere die Heizfrequenzeinheiten 50 der zweiten der Energieversorgungsteileinheiten 56, 58 ist an eine zweite Netzstromspannungsphase angeschlossen, welche sich von der ersten Netzstromspannungsphase unterscheidet.

Im vorliegenden Ausführungsbeispiel weist jede Heizfrequenzeinheit 50 einen insbesondere einzigen Energieversorgungsausgang 24 auf. Die Energieversorgungseinheit 22 weist im vorliegenden Ausführungsbeispiel eine Anzahl an insgesamt sechs Energieversorgungsausgängen 24 auf. Pro Energieversorgungsteileinheit 56, 58 weist die Energieversorgungseinheit 22 drei Energieversorgungsausgänge 24 auf.

Jede der Hauptenergieversorgungsplatinen 16 weist eine Leiterplatte 28 auf. Die Leiterplatte 28 insbesondere einer jeden der Hauptenergieversorgungsplatinen 16 ist zu einer mechanischen Befestigung und/oder zu einer elektrischen Kontaktierung zumindest einer elektrischen und/oder elektronischen Baueinheit vorgesehen.

Jede der Hauptenergieversorgungsplatinen 16 weist eine Kühlungseinheit 26 auf. Die Kühlungseinheit 26 insbesondere einer jeden der Hauptenergieversorgungsplatinen 16 ist auf der Leiterplatte 28 insbesondere der entsprechenden der Hauptenergieversorgungsplatinen 16 angeordnet. Die Kühlungseinheit 26 insbesondere einer jeden der Hauptenergieversorgungsplatinen 16 ist zu einer Kühlung der Energieversorgungseinheit 22 der entsprechenden Hauptenergieversorgungsplatinen 16 vorgesehen.

Im vorliegenden Ausführungsbeispiel weist die Kühlungseinheit 26 insbesondere einer jeden der Hauptenergieversorgungsplatinen 16 zwei Kühlungsteileinheiten 60, 62 auf. Jede der Kühlungsteileinheiten 60, 62 insbesondere einer jeden der Hauptenergieversorgungsplatinen 16 ist zu einer Kühlung einer der Energieversorgungsteileinheiten 56, 58 der entsprechenden Hauptenergieversorgungsplatinen 16 vorgesehen.

Über die Energieversorgungsausgänge 24 der Energieversorgungseinheit 22 ist die entsprechende der Hauptenergieversorgungsplatinen 16 in einem Betriebszustand mit zumindest einer der Nebenenergieversorgungsplatinen 18, insbesondere mit zwei der Nebenenergieversorgungsplatinen 18, verbunden.

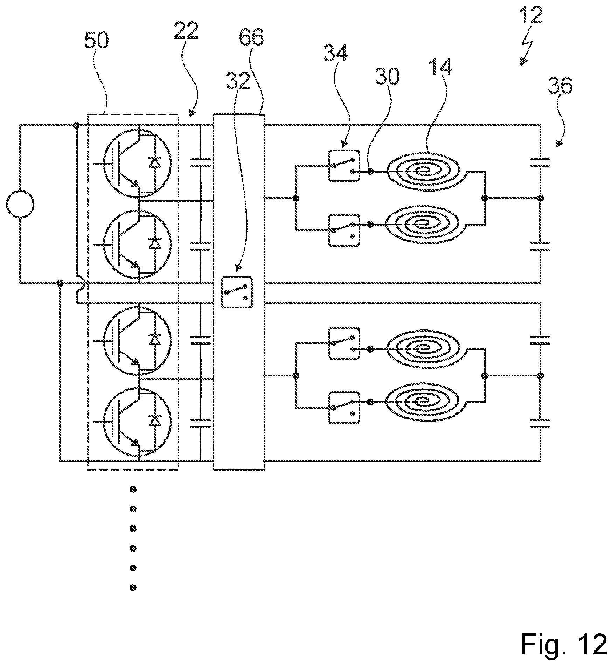

Jeweils drei der Nebenenergieversorgungsplatinen 18 unterscheiden sich im vorliegenden Ausführungsbeispiel hinsichtlich einer Anzahl an Heizeinheitenausgängen 30 (vgl. Fig. 5 und 12). Der Satz von Nebenenergieversorgungsplatinen 18 weist jeweils zwei Nebenenergieversorgungsplatinen 18 auf, welche eine identische Anzahl an Heizeinheitenausgängen 30 aufweisen.

Zumindest eine Nebenenergieversorgungsplatine 18a der Nebenenergieversorgungsplatinen 18 weist eine erste Anzahl an Heizeinheitenausgängen 30 auf. Zumindest eine Nebenenergieversorgungsplatine 18a der Nebenenergieversorgungsplatinen 18 weist eine zweite Anzahl an Heizeinheitenausgängen 30 auf, welche von der ersten Anzahl an Heizeinheitenausgängen 30 verschieden ist. Zumindest eine Nebenenergieversorgungsplatine 18a der Nebenenergieversorgungsplatinen 18 weist eine dritte Anzahl an Heizeinheitenausgängen 30 auf, welche von der ersten Anzahl an Heizeinheitenausgängen 30 und von der zweiten Anzahl an Heizeinheitenausgängen 30 verschieden ist.

Zumindest eine Nebenenergieversorgungsplatine 18a der Nebenenergieversorgungsplatinen 18 weist eine Anzahl an achtundzwanzig Heizeinheitenausgängen 30a auf. Im vorliegenden Ausführungsbeispiel weisen zwei Nebenenergieversorgungsplatinen 18a der Nebenenergieversorgungsplatinen 18 eine Anzahl an achtundzwanzig Heizeinheitenausgängen 30a auf.

Zumindest eine Nebenenergieversorgungsplatine 18b der Nebenenergieversorgungsplatinen 18 weist eine Anzahl an vierundzwanzig Heizeinheitenausgängen 30b auf. Im vorliegenden Ausführungsbeispiel weisen zwei Nebenenergieversorgungsplatinen 18b der Nebenenergieversorgungsplatinen 18 eine Anzahl an vierundzwanzig Heizeinheitenausgängen 30b auf.

Zumindest eine Nebenenergieversorgungsplatine 18c der Nebenenergieversorgungsplatinen 18 weist eine Anzahl an sechzehn Heizeinheitenausgängen 30c auf. Im vorliegenden Ausführungsbeispiel weisen zwei Nebenenergieversorgungsplatinen 18c der Nebenenergieversorgungsplatinen 18 eine Anzahl an sechzehn Heizeinheitenausgängen 30c auf.

Jeweils drei der Nebenenergieversorgungsplatinen 18 unterscheiden sich im vorliegenden Ausführungsbeispiel hinsichtlich einer Anzahl an Zuordnungsschaltelementen 32. Die Zuordnungsschaltelemente 32 sind jeweils zu einer Zuordnung der Heizeinheitenausgänge 30 zu der Energieversorgungseinheit 22 vorgesehen. Der Satz von Nebenenergieversorgungsplatinen 18 weist jeweils zwei Nebenenergieversorgungsplatinen 18 auf, welche eine identische Anzahl an Zuordnungsschaltelementen 32 aufweisen.

Zumindest eine Nebenenergieversorgungsplatine 18a der Nebenenergieversorgungsplatinen 18 weist eine erste Anzahl an Zuordnungsschaltelementen 32 auf. Zumindest eine Nebenenergieversorgungsplatine 18a der Nebenenergieversorgungsplatinen 18 weist eine zweite Anzahl an Zuordnungsschaltelementen 32 auf, welche von der ersten Anzahl an Zuordnungsschaltelementen 32 verschieden ist. Zumindest eine Nebenenergieversorgungsplatine 18a der Nebenenergieversorgungsplatinen 18 weist eine dritte Anzahl an Zuordnungsschaltelementen 32 auf, welche von der ersten Anzahl an Zuordnungsschaltelementen 32 und von der zweiten Anzahl an Zuordnungsschaltelementen 32 verschieden ist.

Jede der Nebenenergieversorgungsplatinen 18 weist eine Zuordnungsschalteinheit 66 auf. Die Zuordnungsschaltelemente 32 der jeweiligen Nebenenergieversorgungsplatine 18 sind Teil der Zuordnungsschalteinheit 66. Die Zuordnungsschalteinheit 66 ist zu einer Zuordnung der Heizeinheitenausgänge 30 zu der Energieversorgungseinheit 22 vorgesehen.

Jeweils drei der Nebenenergieversorgungsplatinen 18 unterscheiden sich im vorliegenden Ausführungsbeispiel hinsichtlich einer Anzahl an Aktivierungsschaltelementen 34. Die Aktivierungsschaltelemente 34 sind jeweils einem der Heizeinheitenausgänge 30 zugeordnet und zu einer Aktivierung und/oder Deaktivierung des jeweiligen Heizeinheitenausgangs 30 vorgesehen. Der Satz von Nebenenergieversorgungsplatinen 18 weist jeweils zwei Nebenenergieversorgungsplatinen 18 auf, welche eine identische Anzahl an Aktivierungsschaltelementen 34 aufweisen. Jede der Nebenenergieversorgungsplatinen 18 weist eine Anzahl an Aktivierungsschaltelementen 34 auf, welche identisch mit einer Anzahl an Heizeinheitenausgängen 30 der jeweiligen Nebenenergieversorgungsplatine 18 ist.

Zumindest eine Nebenenergieversorgungsplatine 18a der Nebenenergieversorgungsplatinen 18 weist eine erste Anzahl an Aktivierungsschaltelementen 34 auf. Zumindest eine Nebenenergieversorgungsplatine 18a der Nebenenergieversorgungsplatinen 18 weist eine zweite Anzahl an Aktivierungsschaltelementen 34 auf, welche von der ersten Anzahl an Aktivierungsschaltelementen 34 verschieden ist. Zumindest eine Nebenenergieversorgungsplatine 18a der Nebenenergieversorgungsplatinen 18 weist eine dritte Anzahl an Aktivierungsschaltelementen 34 auf, welche von der ersten Anzahl an Aktivierungsschaltelementen 34 und von der zweiten Anzahl an Aktivierungsschaltelementen 34 verschieden ist.

Zumindest eine Nebenenergieversorgungsplatine 18a der Nebenenergieversorgungsplatinen 18 weist eine Anzahl an achtundzwanzig Aktivierungsschaltelementen 34a auf. Im vorliegenden Ausführungsbeispiel weisen zwei Nebenenergieversorgungsplatinen 18a der Nebenenergieversorgungsplatinen 18 eine Anzahl an achtundzwanzig Aktivierungsschaltelementen 34a auf.

Zumindest eine Nebenenergieversorgungsplatine 18b der Nebenenergieversorgungsplatinen 18 weist eine Anzahl an vierundzwanzig Aktivierungsschaltelementen 34b auf. Im vorliegenden Ausführungsbeispiel weisen zwei Nebenenergieversorgungsplatinen 18b der Nebenenergieversorgungsplatinen 18 eine Anzahl an vierundzwanzig Aktivierungsschaltelementen 34b auf.

Zumindest eine Nebenenergieversorgungsplatine 18c der Nebenenergieversorgungsplatinen 18 weist eine Anzahl an sechzehn Aktivierungsschaltelementen 34c auf. Im vorliegenden Ausführungsbeispiel weisen zwei Nebenenergieversorgungsplatinen 18c der Nebenenergieversorgungsplatinen 18 eine Anzahl an sechzehn Aktivierungsschaltelementen 34c auf.

Jeweils drei der Nebenenergieversorgungsplatinen 18 unterscheiden sich im vorliegenden Ausführungsbeispiel hinsichtlich einer Anzahl an kapazitiven Baueinheiten 36. Die kapazitiven Baueinheiten 36 sind jeweils einem der Heizeinheitenausgänge 30 zugeordnet und als Resonanzkapazitäten ausgebildet. Der Satz von Nebenenergieversorgungsplatinen 18 weist jeweils zwei Nebenenergieversorgungsplatinen 18 auf, welche eine identische Anzahl an kapazitiven Baueinheiten 36 aufweisen. Jede der Nebenenergieversorgungsplatinen 18 weist eine Anzahl an kapazitiven Baueinheiten 36 auf, welche identisch mit einer Anzahl an Heizeinheitenausgängen 30 der jeweiligen Nebenenergieversorgungsplatine 18 ist.

Zumindest eine Nebenenergieversorgungsplatine 18a der Nebenenergieversorgungsplatinen 18 weist eine erste Anzahl an kapazitiven Baueinheiten 36 auf. Zumindest eine Nebenenergieversorgungsplatine 18a der Nebenenergieversorgungsplatinen 18 weist eine zweite Anzahl an kapazitiven Baueinheiten 36 auf, welche von der ersten Anzahl an kapazitiven Baueinheiten 36 verschieden ist. Zumindest eine Nebenenergieversorgungsplatine 18a der Nebenenergieversorgungsplatinen 18 weist eine dritte Anzahl an kapazitiven Baueinheiten 36 auf, welche von der ersten Anzahl an kapazitiven Baueinheiten 36 und von der zweiten Anzahl an kapazitiven Baueinheiten 36 verschieden ist.

Zumindest eine Nebenenergieversorgungsplatine 18a der Nebenenergieversorgungsplatinen 18 weist eine Anzahl an achtundzwanzig kapazitiven Baueinheiten 36a auf. Im vorliegenden Ausführungsbeispiel weisen zwei Nebenenergieversorgungsplatinen 18a der Nebenenergieversorgungsplatinen 18 eine Anzahl an achtundzwanzig kapazitiven Baueinheiten 36a auf.

Zumindest eine Nebenenergieversorgungsplatine 18b der Nebenenergieversorgungsplatinen 18 weist eine Anzahl an vierundzwanzig kapazitiven Baueinheiten 36b auf. Im vorliegenden Ausführungsbeispiel weisen zwei Nebenenergieversorgungsplatinen 18b der Nebenenergieversorgungsplatinen 18 eine Anzahl an vierundzwanzig kapazitiven Baueinheiten 36b auf.

Zumindest eine Nebenenergieversorgungsplatine 18c der Nebenenergieversorgungsplatinen 18 weist eine Anzahl an sechzehn kapazitiven Baueinheiten 36c auf. Im vorliegenden Ausführungsbeispiel weisen zwei Nebenenergieversorgungsplatinen 18c der Nebenenergieversorgungsplatinen 18 eine Anzahl an sechzehn kapazitiven Baueinheiten 36c auf.

Jeweils drei der Nebenenergieversorgungsplatinen 18 unterscheiden sich im vorliegenden Ausführungsbeispiel bei einer Betrachtung in einer Draufsicht auf eine Haupterstreckungsebene der jeweiligen Nebenenergieversorgungsplatine 18 hinsichtlich einer Flächenerstreckung. Der Satz von Nebenenergieversorgungsplatinen 18 weist jeweils zwei Nebenenergieversorgungsplatinen 18 auf, welche bei einer Betrachtung in einer Draufsicht auf eine Haupterstreckungsebene der jeweiligen Nebenenergieversorgungsplatine 18 eine identische Flächenerstreckung aufweisen.

Jede der Nebenenergieversorgungsplatinen 18 weist eine Leiterplatte 64 auf. Die Leiterplatte 64 der jeweiligen Nebenenergieversorgungsplatinen 18 definieren bei einer Betrachtung in einer Draufsicht auf eine Haupterstreckungsebene der jeweiligen Nebenenergieversorgungsplatine 18 die Flächenerstreckung der entsprechenden Nebenenergieversorgungsplatine 18.

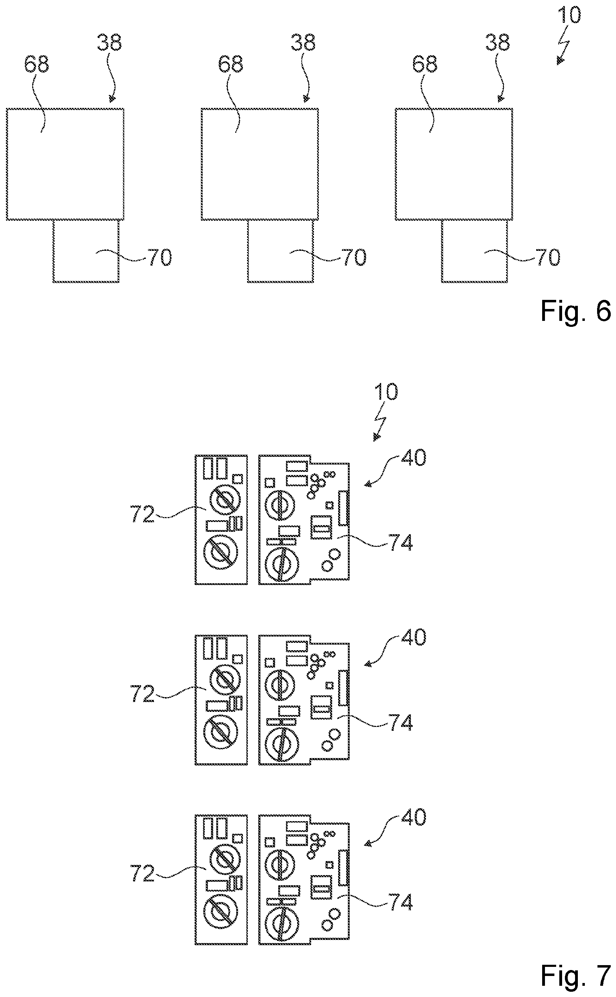

Der Bausatz 10 weist einen Satz von identischen Gebläseeinheiten 38 auf (vgl. Fig. 6). Die Gebläseeinheiten 38 sind zu einer Herstellung von Kochfeldern 12 mit unterschiedlicher Anzahl an Heizeinheiten 14 wahlweise mit einer der Hauptenergieversorgungsplatinen 16 verbindbar.

Jede der Gebläseeinheiten 38 weist ein Lüfterrad auf (nicht dargestellt), welches insbesondere zu einer Bereitstellung zumindest eines Luftstroms vorgesehen ist. Die Gebläseeinheit 38 weist ein Gebläsegehäuse 68 auf. Das Lüfterrad ist innerhalb des Gebläsegehäuses 68 angeordnet. Die Gebläseeinheit 38 weist eine Kanaleinheit 70 auf. Die Kanaleinheit 70 verbindet in einem Betriebszustand das Lüfterrad und die Kühlungseinheit 26 strömungstechnisch miteinander (vgl. Fig. 11).

Der Bausatz 10 weist einen Satz von identischen Filtereinheiten 40 auf (vgl. Fig. 7). Die Filtereinheiten 40 sind zu einer Herstellung von Kochfeldern 12 mit unterschiedlicher Anzahl an Heizeinheiten 14 wahlweise mit einer der Hauptenergieversorgungsplatinen 16 verbindbar.

Jede der Filtereinheiten 40 ist zweiteilig ausgebildet. Jede der Filtereinheiten 40 weist eine erste Filterteileinheit 72 und eine zweite Filterteileinheit 74 auf. Jede der Filterteileinheiten 72, 74 weist einen Filter auf. Die Filterteileinheiten 72, 74 unterscheiden sich hinsichtlich zumindest eines Merkmals voneinander.

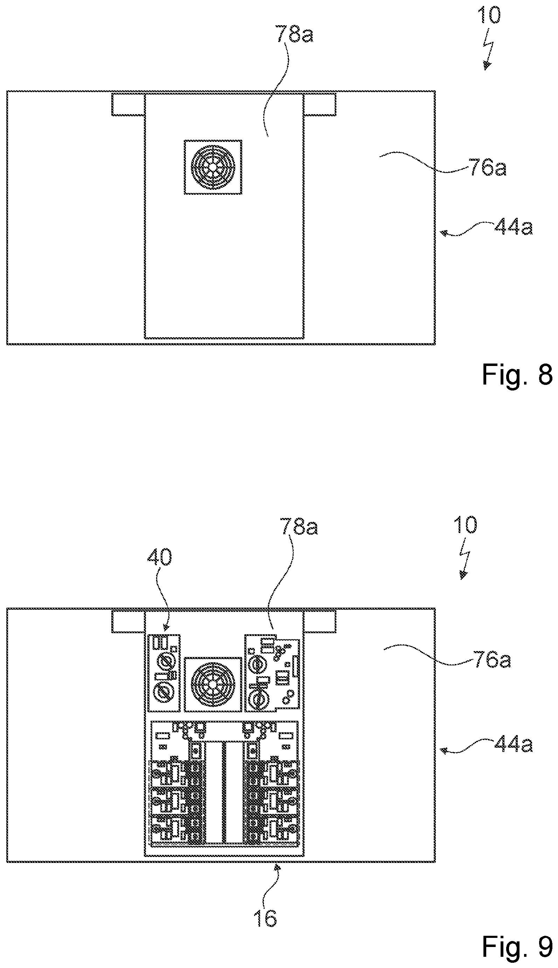

In einem Verfahren zu einer Herstellung eines Kochfelds 14 mittels des Bausatzes 10 wird aus dem Satz von Kochfeldaußengehäuseeinheiten 44 eine der Kochfeldaußengehäuseeinheiten 44 ausgewählt (vgl. Fig. 8). Aus dem Satz von identischen Hauptenergieversorgungsplatinen 16 wird eine der Hauptenergieversorgungsplatinen 16 ausgewählt und insbesondere innerhalb der Kochfeldaußengehäuseeinheit 44 angeordnet (vgl. Fig. 9). Aus dem Satz von identischen Filtereinheiten 40 wird eine der Filtereinheiten 40 ausgewählt und insbesondere innerhalb der Kochfeldaußengehäuseeinheit 44 angeordnet. Die ausgewählte Filtereinheit 40 wird wahlweise mit der Hauptenergieversorgungsplatine 16 verbunden.

Aus dem Satz von Nebenenergieversorgungsplatinen 18 werden zwei identische der Nebenenergieversorgungsplatinen 18 ausgewählt und insbesondere innerhalb der Kochfeldaußengehäuseeinheit 44 angeordnet (vgl. Fig. 10). Die ausgewählten Nebenenergieversorgungsplatinen 18 werden wahlweise mit der Hauptenergieversorgungsplatine 16 verbunden.

Aus dem Satz von Gebläseeinheiten 38 wird eine der Gebläseeinheiten 38 ausgewählt und insbesondere innerhalb der Kochfeldaußengehäuseeinheit 44 angeordnet (vgl. Fig. 11). Die ausgewählte Gebläseeinheit 38 wird wahlweise mit der Hauptenergieversorgungsplatine 16 verbunden.

### Bezugszeichen

- 10: Bausatz
- 12: Kochfeld
- 14: Heizeinheit
- 16: Hauptenergieversorgungsplatine
- 18: Nebenenergieversorgungsplatine
- 20: Hauptsteuereinheit
- 22: Energieversorgungseinheit
- 24: Energieversorgungsausgang
- 26: Kühlungseinheit
- 28: Leiterplatte
- 30: Heizeinheitenausgang
- 32: Zuordnungsschaltelement
- 34: Aktivierungsschaltelement
- 36: Kapazitive Baueinheit
- 38: Gebläseeinheit
- 40: Filtereinheit
- 42: Aufstellplatte
- 44: Kochfeldaußengehäuseeinheit
- 46: Bedienerschnittstelle
- 48: Kochfeldsteuereinheit
- 50: Heizfrequenzeinheit
- 52: Steuerteileinheit
- 54: Steuerteileinheit
- 56: Energieversorgungsteileinheit
- 58: Energieversorgungsteileinheit
- 60: Kühlungsteileinheit
- 62: Kühlungsteileinheit
- 64: Leiterplatte
- 66: Zuordnungsschalteinheit
- 68: Gebläsegehäuse
- 70: Kanaleinheit
- 72: Erste Filterteileinheit
- 74: Zweite Filterteileinheit
- 76: Außengehäuseeinheit
- 78: Innengehäuseeinheit

## Patentansprüche

1. Bausatz (10), insbesondere Kochfeldbausatz, zu einer Herstellung von Kochfeldern (12) mit unterschiedlicher Anzahl an Heizeinheiten (14), mit einem Satz von identischen Hauptenergieversorgungsplatinen (16) und mit einem Satz von Nebenenergieversorgungsplatinen (18), welche zu einer Herstellung von Kochfeldern (12) mit unterschiedlicher Anzahl an Heizeinheiten (14) wahlweise mit einer der Hauptenergieversorgungsplatinen (16) verbindbar sind, **dadurch gekennzeichnet, dass** die Nebenenergieversorgungsplatinen (18) zu einer Ansteuerung durch die Hauptenergieversorgungsplatinen (16) vorgesehen sind, und wobei durch die Nebenenergieversorgungsplatinen (18) in wenigstens einem Betriebszustand Energie bereitstellbar ist, insbesondere ausschließlich gemeinsam mit der Hauptenergieversorgungsplatine (16).

2. Bausatz (10) nach Anspruch 1, **dadurch gekennzeichnet, dass** jede der Hauptenergieversorgungsplatinen (16) zumindest eine Hauptsteuereinheit (20) aufweist, welche zu einer Steuerung der Heizeinheiten (14) vorgesehen ist.

3. Bausatz (10) nach Anspruch 1 oder 2, **dadurch gekennzeichnet, dass** jede der Hauptenergieversorgungsplatinen (16) zumindest eine Energieversorgungseinheit (22) aufweist, welche zu einer Versorgung der Heizeinheiten (14) mit elektrischer Energie vorgesehen ist.

4. Bausatz (10) nach Anspruch 3, **dadurch gekennzeichnet, dass** jede der Hauptenergieversorgungsplatinen (16) zumindest eine Leiterplatte (28) und zumindest eine Kühlungseinheit (26) aufweist, welche auf der Leiterplatte (28) angeordnet und zu einer Kühlung der Energieversorgungseinheit (22) vorgesehen ist.

5. Bausatz (10) nach Anspruch 3 oder 4, **dadurch gekennzeichnet, dass** die Energieversorgungseinheit (22) eine Anzahl an maximal zwölf Energieversorgungsausgängen (24) aufweist.

6. Bausatz (10) nach einem der vorhergehenden Ansprüche, **dadurch gekennzeichnet, dass** sich zumindest zwei der Nebenenergieversorgungsplatinen (18) hinsichtlich einer Anzahl an Heizeinheitenausgängen (30) unterscheiden.

7. Bausatz (10) zumindest nach den Ansprüchen 3 und 6, **dadurch gekennzeichnet, dass** sich zumindest zwei der Nebenenergieversorgungsplatinen (18) hinsichtlich einer Anzahl an Zuordnungsschaltelementen (32) unterscheiden, welche zu einer Zuordnung der Heizeinheitenausgänge (30) zu der Energieversorgungseinheit (22) vorgesehen sind.

8. Bausatz (10) nach Anspruch 6 oder 7, **dadurch gekennzeichnet, dass** sich zumindest zwei der Nebenenergieversorgungsplatinen (18) hinsichtlich einer Anzahl an Aktivierungsschaltelementen (34) unterscheiden, welche jeweils einem der Heizeinheitenausgänge (30) zugeordnet und zu einer Aktivierung und/oder Deaktivierung des jeweiligen Heizeinheitenausgangs (30) vorgesehen sind.

9. Bausatz (10) nach einem der vorhergehenden Ansprüche, **dadurch gekennzeichnet, dass** sich zumindest zwei der Nebenenergieversorgungsplatinen (18) hinsichtlich einer Anzahl an kapazitiven Baueinheiten (36) unterscheiden.

10. Bausatz (10) nach einem der vorhergehenden Ansprüche, **dadurch gekennzeichnet, dass** sich zumindest zwei der Nebenenergieversorgungsplatinen (18) bei einer Betrachtung in einer Draufsicht auf eine Haupterstreckungsebene der jeweiligen Nebenenergieversorgungsplatine (18) hinsichtlich einer Flächenerstreckung unterscheiden.

11. Bausatz (10) nach einem der vorhergehenden Ansprüche, **gekennzeichnet durch** einen Satz von identischen Gebläseeinheiten (38), welche zu einer Herstellung von Kochfeldern (12) mit unterschiedlicher Anzahl an Heizeinheiten (14) wahlweise mit einer der Hauptenergieversorgungsplatinen (16) verbindbar sind.

12. Bausatz (10) nach einem der vorhergehenden Ansprüche, **gekennzeichnet durch** einen Satz von identischen Filtereinheiten (40), welche zu einer Herstellung von Kochfeldern (12) mit unterschiedlicher Anzahl an Heizeinheiten (14) wahlweise mit einer der Hauptenergieversorgungsplatinen (16) verbindbar sind.

13. Kochfeld (12), insbesondere Induktionskochfeld, welches mittels eines Bausatzes (10) nach einem der vorhergehenden Ansprüche hergestellt ist.

14. Verfahren zu einer Herstellung eines Kochfelds (12) mittels eines Bausatzes (10) gemäss einem der Ansprüche 1 bis 12, zu einer Herstellung von Kochfeldern (12) mit unterschiedlicher Anzahl an Heizeinheiten (14), wobei der Bausatz (10) einen Satz von identischen Hauptenergieversorgungsplatinen (16) und einen Satz von Nebenenergieversorgungsplatinen (18) aufweist, welche zu einer Herstellung von Kochfeldern (12) mit unterschiedlicher Anzahl an Heizeinheiten (14) wahlweise mit einer der Hauptenergieversorgungsplatinen (16) verbunden werden.

## Claims

1. Kit (10), in particular hob kit, for producing hobs (12) with a different number of heating units (14), having a set of identical main power supply circuit boards (16) and having a set of additional power supply circuit boards (18) which can optionally be connected to one of the main power supply circuit boards (16) in order to produce hobs (12) with a different number of heating units (14), **characterised in that** the additional power supply circuit boards (18) are provided for activation by means of the main power supply circuit boards (16), and wherein power can be provided by the additional power supply circuit boards (18) in at least one operating state, in particular exclusively together with the main power supply circuit board (16).

2. Kit (10) according to claim 1, **characterised in that** each of the main power supply circuit boards (16) has at least one main control unit (20) which is provided to control the heating units (14).

3. Kit (10) according to claim 1 or 2, **characterised in that** each of the main power supply circuit boards (16) has at least one power supply unit (22), which is provided to supply the heating units (14) with electrical power.

4. Kit (10) according to claim 3, **characterised in that** each of the main power supply circuit boards (16) has at least conductor plate (28) and at least one cooling unit (26), which is arranged on the conductor plate (28) and provided for cooling the power supply unit (22).

5. Kit (10) according to claim 3 or 4, **characterised in that** the power supply unit (22) has a number of at most 12 power supply outputs (24).

6. Kit (10) according to one of the preceding claims, **characterised in that** at least two of the additional power supply circuit boards (18) differ in respect of a number of heating unit outputs (30).

7. Kit (10) at least according to claims 3 and 6, **characterised in that** at least two of the additional power supply circuit boards (18) differ in respect of a number of assignment switching elements (32), which are provided for assigning the heating unit outputs (30) to the power supply unit (22).

8. Kit (10) according to claim 6 or 7, **characterised in that** at least two of the additional power supply circuit boards (18) differ in respect of a number of activation switching elements (34), which are each assigned to one of the heating unit outputs (30) and provided to activate and/or deactivate the respective heating unit output (30).

9. Kit (10) according to one of the preceding claims, **characterised in that** at least two of the additional power supply circuit boards (18) differ in respect of a number of capacitive structural units (36).

10. Kit (10) according to one of the preceding claims, **characterised in that** at least two of the additional power supply circuit boards (18) differ in respect of a surface extension when viewed in a top view onto a main extension plane of the respective additional power supply circuit board (18).

11. Kit (10) according to one of the preceding claims, **characterised by** a set of identical fan units (38), which can optionally be connected to one of the main power supply circuit boards (16) in order to produce hobs (12) with a different number of heating units (14).

12. Kit (10) according to one of the preceding claims, **characterised by** a set of identical filter units (40), which can optionally be connected to one of the main power supply circuit boards (16) in order to produce hobs (12) with a different number of heating units (14).

13. Hob (12), in particular induction hob, which is manufactured by means of a kit (10) according to one of the preceding claims.

14. Method for producing a hob (12) by means of a kit (10) according to one of claims 1 to 12, for producing hobs (12) with a different number of heating units (14), wherein the kit (10) has a set of identical main power supply circuit boards (16) and a set of additional power supply circuit boards (18), which are optionally connected to one of the main power supply circuit boards (16) in order to produce hobs (12) with a different number of heating units (14).

## Revendications

1. Ensemble modulaire (10), en particulier ensemble modulaire de table de cuisson, destiné à la fabrication de tables de cuisson (12) ayant un nombre différent d'unités de chauffage (14), comprenant un ensemble de platines d'alimentation d'énergie principale (16) identiques et un ensemble de platines d'alimentation d'énergie auxiliaire (18), qui peuvent être connectées sélectivement à l'une des platines d'alimentation d'énergie principale (16) pour fabriquer des tables de cuisson (12) ayant un nombre différent d'unités de chauffage (14),
**caractérisé en ce que** les platines d'alimentation d'énergie auxiliaire (18) sont configurées pour être excitées par les platines d'alimentation d'énergie principale (16), et dans lequel de l'énergie peut être fournie par les platines d'alimentation d'énergie auxiliaire (18) dans au moins un état de fonctionnement, en particulier strictement en commun avec la platine d'alimentation d'énergie principale (16).

2. Ensemble modulaire (10) selon la revendication 1, **caractérisé en ce que** chacune des platines d'alimentation d'énergie principale (16) comprend au moins une unité de commande principale (20), qui est conçue pour commander les unités de chauffage (14).

3. Ensemble modulaire (10) selon la revendication 1 ou 2, **caractérisé en ce que** chacune des platines d'alimentation d'énergie principale (16) comprend au moins une unité d'alimentation d'énergie (22), qui est conçue pour alimenter les unités de chauffage (14) avec de l'énergie électrique.

4. Ensemble modulaire (10) selon la revendication 3, **caractérisé en ce que** chacune des platines d'alimentation d'énergie principale (16) comprend au moins une carte à circuit imprimé (28) et au moins une unité de refroidissement (26), qui est disposée sur la carte à circuit imprimé (28) et qui est conçue pour refroidir l'unité d'alimentation d'énergie (22).

5. Ensemble modulaire (10) selon la revendication 3 ou 4, **caractérisé en ce que** l'unité d'alimentation d'énergie (22) comprend un nombre maximal de douze sorties d'alimentation d'énergie (24).

6. Ensemble modulaire (10) selon l'une quelconque des revendications précédentes, **caractérisé en ce qu'**au moins deux des platines d'alimentation d'énergie auxiliaire (18) diffèrent en ce qui concerne un nombre de sorties d'unité de chauffage (30).

7. Ensemble modulaire (10) au moins selon les revendications 3 et 6, **caractérisé en ce qu'**au moins deux des platines d'alimentation d'énergie auxiliaire (18) diffèrent en ce qui concerne un nombre d'éléments de commutation d'affectation (32), qui sont conçus pour associer les sorties d'unités de chauffage (30) à l'unité d'alimentation d'énergie (22).

8. Ensemble modulaire (10) selon la revendication 6 ou 7, **caractérisé en ce qu'**au moins deux des platines d'alimentation d'énergie auxiliaire (18) diffèrent en ce qui concerne un nombre d'éléments de commutation d'activation (34), qui sont associés respectivement à une des sorties d'unité de chauffage (30) et sont conçus pour activer et/ou désactiver la sortie d'unité de chauffage (30) respective.

9. Ensemble modulaire (10) selon l'une des revendications précédentes, **caractérisé en ce qu'**au moins deux des platines d'alimentation d'énergie auxiliaire (18) se différencient en ce qui concerne un nombre de composants capacitifs (36).

10. Ensemble modulaire (10) selon l'une des revendications précédentes, **caractérisé en ce qu'**au moins deux des platines d'alimentation d'énergie auxiliaire (18) se différencient en termes d'une étendue de surface, lorsqu'on observe dans une vue de dessus sur le plan d'extension principal de la platine d'alimentation d'énergie auxiliaire (18) respective.

11. Ensemble modulaire (10) selon l'une des revendications précédentes, **caractérisé par** un ensemble d'unités de ventilateur identiques (38), qui peuvent être reliées sélectivement à l'une des platines d'alimentation d'énergie principale (16) pour fabriquer des tables de cuisson (12) ayant un nombre différent d'unités de chauffage (14).

12. Ensemble modulaire (10) selon l'une des revendications précédentes, **caractérisé par** un ensemble d'unités de filtre identiques (40), qui peuvent être reliées sélectivement à l'une des platines d'alimentation d'énergie principale (16) pour fabriquer des tables de cuisson (12) ayant un nombre différent d'unités de chauffage (14).

13. Table de cuisson (12), notamment table de cuisson à induction, qui est fabriquée au moyen d'un ensemble modulaire (10) selon l'une des revendications précédentes.

14. Procédé de fabrication d'une table de cuisson (12) au moyen d'un ensemble modulaire (10) selon l'une des revendications 1 à 12, pour fabriquer des tables de cuisson (12) ayant un nombre différent d'unités de chauffage (14), dans lequel l'ensemble modulaire (10) comprend un ensemble de platines d'alimentation d'énergie principale (16) identiques et un ensemble de platines d'alimentation d'énergie auxiliaire (18), qui peuvent être connectées sélectivement à une des platines d'alimentation d'énergie principale (16) pour fabriquer des tables de cuisson (12) ayant un nombre différent d'unités de chauffage (14).
